# EUROPÄISCHE PATENTSCHRIFT

(11) **EP 0 634 888 B1**
(45) Veröffentlichungstag und Bekanntmachung des Hinweises auf die Patenterteilung: **19.03.1997**
(21) Anmeldenummer: 94110431.7
(22) Anmeldetag: 05.07.1994
(51) Int. Cl.: H05K 1/11, H01H 11/00, H01R 23/68, H01H 50/02

(54) **Steckbare Baugruppe, insbesondere Relaismodul für Kraftfahrzeuge**
Plug-in unit, particularly relay module for motor vehicles
Unité enfichable, en particulier module de relais pour véhicules automobiles

(30) Priorität: 15.07.1993 DE 4323827
(43) Veröffentlichungstag der Anmeldung: 18.01.1995
(73) Patentinhaber: SIEMENS AKTIENGESELLSCHAFT, 80333 München (DE); FORD-WERKE AKTIENGESELLSCHAFT, 50725 Köln (DE)
(72) Erfinder: Dittmann, Michael, Dipl.-Ing., D-12207 Berlin (DE); Krüger, Erwin, D-50670 Köln (DE)
(74) Vertreter: Fuchs, Franz-Josef, Dr.-Ing.

(56) Entgegenhaltungen:
- EP-A- 0 312 415
- EP-A- 0 358 504
- EP-A- 0 489 654
- DE-A- 1 911 779
- DE-A- 3 001 234
- DE-U- 8 912 914
- US-A- 4 400 761
- US-A- 4 772 761

## Beschreibung

Die Erfindung betrifft eine steckbare Baugruppe mit einer als Formteil aus Kunststoff gebildeten Leiterplatte, in welcher aus mindestens einem Stanzgitter gebildete Leiterbahnen eingebettet sind, wobei auf der Leiterplatte über die Leiterbahnen elektrisch verbundene Bauelemente befestigt sind und wobei an dem Stanzgitter einstückig angeformte Flachstecker aus der Leiterplatte austreten.

Eine steckbare Baugruppe allgemeiner Art ist beispielsweise aus der GB-A- 2 180 415 bekannt. Dort sind elektronische Bauelemente auf einer herkömmlichen Leiterplatte angeordnet, welche ihrerseits in einem Gehäuse befestigt ist. Durch die Gehäusewand führende Flachstecker sind mit der Leiterplatte verlötet. Ähnlich ist es bei einem Lastschaltmodul für Kraftfahrzeuge, das aus der DE-A1 38 41 893 bekannt ist. Auch dort sind Anschlußelemente mit der Leiterplatte verlötet, wobei es sich jedoch nicht um Flachstecker handelt.

Bei einem in der DE-A1-33 45 701 beschriebenen elektrischen Schaltgerät sind vorzugsweise zwei Leiterplatten parallel angeordnet und an einem Ende mit einer sockelähnlichen Anschlußplatte verbunden, welche auf ihrer Oberfläche aus einem Stanzgitter gebildete Blechstreifen zur Kontaktierung der Leiterbahnen mit runden Anschlußstiften im Sockel trägt. Die Blechstreifen sind jeweils an ihren Enden mit den Leiterbahnen der Leiterplatten verlötet.

In der DE-A1-29 39 266 ist eine Baueinheit aus einem Relais und einer Schaltungsplatte beschrieben, wobei die Anschlußstifte des Relais durch die Schaltungsplatte hindurchgeführt sind und zusammen mit eigenen Anschlußstiften der Schaltungsplatte die Anschlüsse der Baueinheit bilden. Für die Schaltungsplatte bei dieser Baueinheit gilt ebenso wie bei den vorher erwähnten Leiterplatten, daß die oberflächlich kaschierten Leiterbahnen für die Führung großer Lastströme, wie sie etwa bei Kraftfahrzeugrelais fließen, nicht geeignet sind.

Aus der DE-A1-37 06 964 ist ferner eine elektrische Baugruppe mit einer Mehrzahl von Bauelementen bekannt, bei der keine eigentliche Leiterplatte vorhanden ist, sondern die durch ein Stanzgitter gebildeten Leiterbahnen selbst den tragenden Teil der Baugruppe bilden. Diese Stanzteile bilden auch einstückig angeformte Stecker.

Bei einer in DE-C2-31 47 674 beschriebenen Fassung für ein Miniaturrelais sind in einem Isolierkörper eingesteckte metallische Brücken teilweise auch mit einstückig angeformten Flachsteckern versehen. Die Fassung ist jedoch nur zur Adaptierung eines einzigen Relais geeignet, so daß weder von einer Baugruppe noch von einer Leiterplatte mit Leiterbahnen zur Verbindung mehrerer Bauelemente gesprochen werden kann.

Aus der DE-U-89 12 914 ist eine steckbare Baugruppe der eingangs genannten Art bekannt, wobei eine Leiteranordnung aus ebenen Blechstreifen zur Bildung von Leiterträgern teilweise mit Kunststoff umspritzt ist. Die Umspritzung erfolgt allerdings nur in einer Ebene der Leiterbahnen; soweit eine Abwinkelung gezeigt ist, erfolgt diese lediglich durch Biegung von nicht umhüllten Blechabschnitten.

In der EP-A-04 89 654 ist weiterhin eine Schalteranordnung für Kraftfahrzeuge beschrieben, wobei grundsätzlich ebenfalls Stanzgitter mit Kunststoff umspritzt werden. Es handelt sich aber auch in diesem Fall nicht um ein einfaches Relaismodul, sondern um eine komplizierte Schalteranordnung mit einem bogenförmigen Gehäuse, wobei ein aus zwei Schalen gebildetes Gehäuse nachträglich mit lose und beweglich eingelegten Schalterteilen bestückt wird. Dabei ist zwar eine Halbschale einstückig mit einer Kunststoffplatine ausgebildet, in welcher auch Leiterbahnen aus einem Stanzgitter eingebettet sind. Eine senkrecht zur Platine stehende Gehäuseschale enthält jedoch keine Flachstecker, sondern flache Kontaktbahnen für einen Drehschalter.

Ziel der Erfindung ist es, eine verbesserte steckbare Baugruppe der eingangs genannten Art zu schaffen, welche möglichst wenig Teile besitzt und sowohl eine hohe mechanische Stabilität als auch eine hohe elektrische Belastbarkeit aufweist, also beispielsweise Stromstärken zu leiten vermag, wie sie bei Kraftfahrzeugrelais im Lastkreis fließen.

Erfindungsgemäß wird dies dadurch erreicht, daß die Leiterplatte einstückig mindestens zwei zueinander senkrechte Leiterplattenebenen bildet, in denen sich das Stanzgitter innerhalb der Einbettung ebenfalls über mindestens zwei zueinander senkrechte Ebenen erstreckt, und daß eine waagerechte Leiterplattenebene einen Sockel für mindestens eine senkrechte Leiterplattenebene bildet, aus dessen Unterseite die Flachstekker austreten.

Erfindungsgemäß erstreckt sich also die Leiterplatte nicht nur in einer Ebene, sondern in zwei zueinander senkrechten Ebenen, so daß ein Leiterplattenkörper mit L-förmigem oder T-förmigem Querschnitt entsteht.

Die Stanzgitter zur Bildung der Leiterbahnen werden in diesem Fall entsprechend abgewinkelt oder abgekröpft. Dabei bildet ein senkrecht stehender Längsschenkel des Leiterplattenkörpers die eigentliche Leiterplatte zur Aufnahme und Kontaktierung der Bauelemente, während ein waagerecht verlaufender Querschenkel als Sockel dient, aus dessen Unterseite die Flachstecker hervortreten. Selbstverständlich können aber auch im Sockelbereich zusätzlich Bauelemente befestigt und kontaktiert sein. Bei dieser Formgestaltung ist es auch möglich, den als Sockel ausgebildeten Querschenkel so zu gestalten, daß er zusammen mit einer über den Längsschenkel gestülpten Kappe ein geschlossenees Gehäuse bildet.

Durch die Verwendung eines Stanzgitters für die Leiterbahnen kann deren Querschnitt durch entsprechende Wahl der Blechdicke so bemessen werden, daß auch höhere Lastströme, beispielsweise von Relais, problemlos geführt werden können. Durch die Einbettung dieser Leiterbahnen in ein Formteil, insbesondere ein Spritzgießteil, erhält die Leiterplatte als Träger nicht nur die gewünschte Stabilität für die Baugruppe, sondern die Leiterbahnen werden auch weitgehend voneinander und gegenüber den aufgesetzten Bauelementen isoliert. Weiterhin sind in dem erwähnten Stanzgitter für die Leiterbahnen aufgrund deren Dicke die Flachstecker für die Baugruppe gleich mit angeformt. Somit ist nicht nur die Anzahl der Teile gering, sondern es sind auch keine Lötstellen für die Kontaktierung der Anschlußstifte erforderlich. Dies ist nicht nur wegen der Einsparung von Löt-Arbeitsgängen von Vorteil, vielmehr sind Lötstellen in Baugruppen mit elektrischen Schaltkontakten unerwünscht, weil das dabei verwendete Kolophonium die Kontaktoberflächen verunreinigen kann. Somit ist es weiterhin vorteilhaft, wenn in besonderer Ausgestaltung der erfindungsgemäßen Baugruppe auch die Bauelemente selbst nicht über Lötstellen, sondern beispielsweise über Schweißpunkte an den Leiterbahnen kontaktiert werden; bei den relativ großen Querschnitten dieser gestanzten Leiterbahnen ist eine Schweißkontaktierung ohne weiteres führbar. Für die Kontaktierung der Bauelemente werden zweckmäßigerweise entsprechende Kontaktstellen der Leiterbahnen bei der Einbettung ausgespart. Für größere Bauelemente ist es weiterhin zweckmäßig, Kontaktlappen der betreffenden Leiterbahnen aus der Ebene des Stanzgitters herauszubiegen und neben diesen Kontaktlappen in der Leiterplatte eine Stecköffnung auszusparen. So können schwerere Bauelemente, wie Relais, durch Einstecken in diese Stecköffnungen der Leiterplatte mechanisch gehaltert und auch für gewisse Anforderungen elektrisch kontaktiert werden. In der Regel werden jedoch die Steckanschlüsse des Bauelementes anschließend mit den Kontaktlappen der Leiterplatte verschweißt.

In einer vorteilhaften Ausgestaltung ist weiterhin vorgesehen, zwei oder auch mehr Leiterbahngruppen in Form von terschiedlichen Stanzgittern in parallelen Ebenen in der Leiterplatte einzubetten. Auf diese Weise ist es möglich, Stanzgitter unterschiedlicher Dicke und damit Leiterbahnen unterschiedlichen Querschnitts vorzusehen, so daß beispielsweise die geringeren Steuerströme über dünne Leiterbahnen und über Anschlußfahnen geringen Querschnitts geführt werden, während hohe Lastströme über entsprechend dickere Leiterbahnen und über Flachstecker großen Querschnitts geführt werden. Die unterschiedlichen Stanzgitter können natürlich auch im Bereich der Leiterplatte direkt oder über zwischengeschaltete Bauelemente verbunden werden, wo dies die trische Schaltung gebietet.

In zweckmäßiger Ausgestaltung kann weiterhin die Leiterplatte sich nicht nur in einer Ebene, sondern in zwei zueinander senkrechten Ebenen erstrecken, so daß ein Leiterplattenkörper mit L-förmigem oder T-förmigem Querschnitt entsteht. Die Stanzgitter zur Bildung der Leiterbahnen werden in diesem Fall entsprechend abgewinkelt oder abgekröpft. Zweckmäßigerweise bildet dabei ein Schenkel, insbesondere ein senkrecht stehender Längsschenkel, die eigentliche Leiterplatte zur Aufnahme und Kontaktierung der Bauelemente, während ein zweiter Schenkel, insbesondere ein waagrecht verlaufender Querschenkel, als Sockel dient, aus dessen Unterseite die Flachstecker hervortreten. Selbstverständlich können aber auch im Sockelbereich zusätzlich Bauelemente befestigt und kontaktiert sein. Bei dieser Formgestaltung ist es auch möglich, den als Sockel ausgebildeten Querschenkel so zu gestalten, daß er zusammen mit einer über den Längsschenkel gestülpten Kappe ein geschlossenes Gehäuse bildet.

Die Erfindung wird nachfolgend an Ausführungsbeispielen anhand der Zeichnung näher erläutert. Es zeigt
Figur 1 eine steckbare Baugruppe, bestückt mit zwei Relais, in perspektivischer Darstellung (ohne Kappe),
Figur 2 eine gegenüber Figur 1 leicht abgewandelte Baugruppe in Seitenansicht mit aufgeschnittener Kappe,
Figur 3 eine Stanzgitteranordnung für eine Leiterplatte ähnlich der, wie sie in Figur 1 oder 2 verwendet ist, und
Figur 4 die durch Umspritzung der Stanzgitteranordnung von Figur 3 gewonnene Leiterplatte, die teilweise mit Bauelementen bestückt ist.

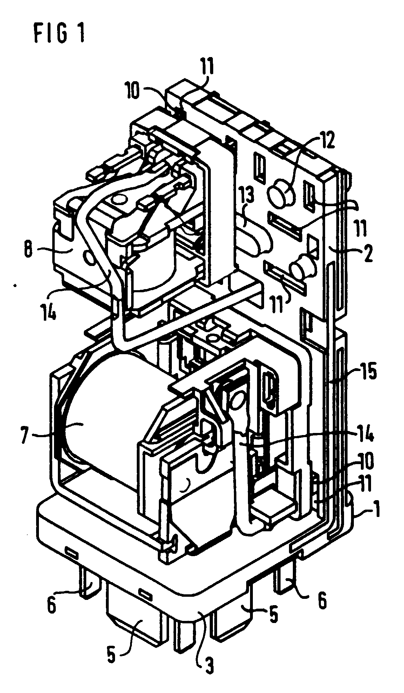

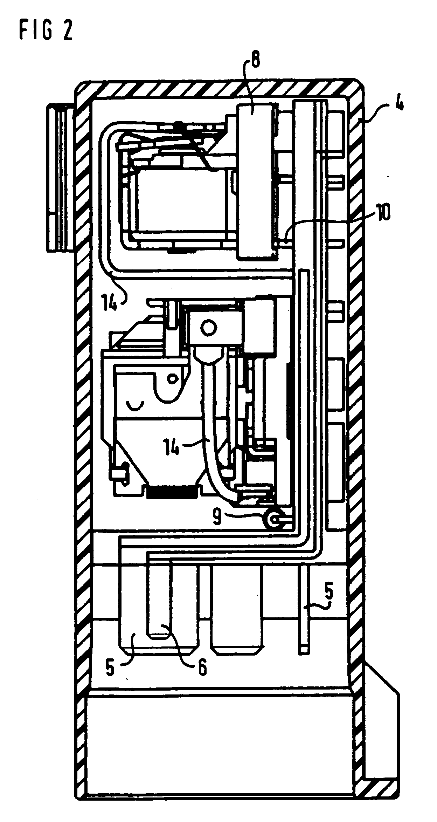

Die in Figur 1 gezeigte Baugruppe besteht aus einer Leiterplatte 1 mit L-förmigem Querschnitt, wobei ein senkrechter Schenkel als eigentlicher Leiterplattenschenkel 2 zur Aufnahme von Bauelementen dient, während ein waagerechter Schenkel als Sockel 3 dient, der zusammen mit einer Kappe 4 (siehe Figur 2) ein geschlossenes Gehäuse bildet. Aus dem Sockel treten nach unten Stecker unterschiedlichen Querschnitts aus, also breite Flachstecker 5 mit großem Querschnitt und schmälere Flachstecker 6 mit geringem Querschnitt. Wie in Figur 2 zu sehen ist, greift die Kappe 4 über den Sockel 3 hinaus auch über den Steckerbereich und umgibt die Stecker 5 und 6 in Form eines Schutzkragens.

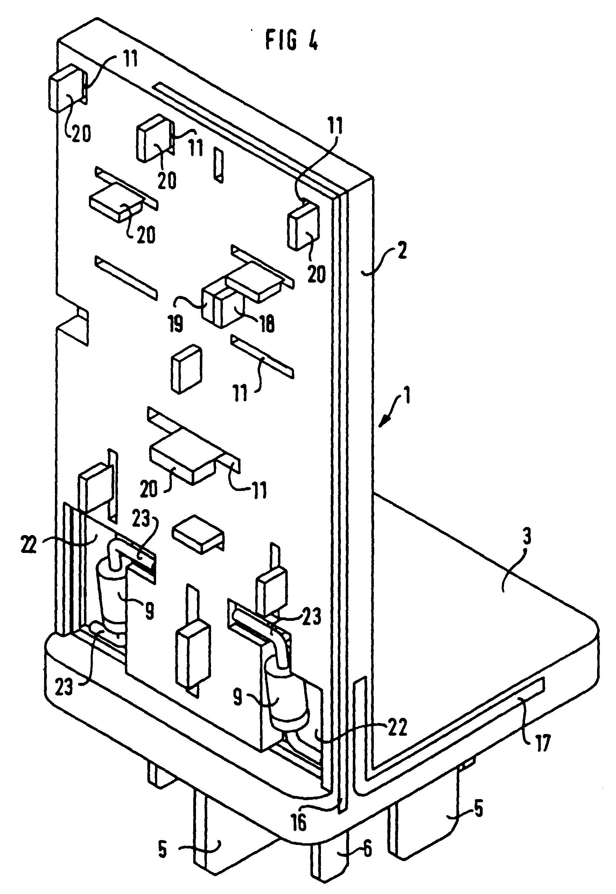

Die Baugruppe enthält bei diesem Beispiel zwei bzw. drei Relais 7 und 8 in unterschiedlicher Größe, außerdem kleinere Bauelemente 9 (siehe Figur 2 und 4); dies können beispielsweise Widerstände oder Dioden sein. Die Relais 7 bzw. 8 sind mit ihren Flachsteckern 10 in Stecköffnungen 11 der Leiterplatte 1 eingesteckt und an der Rückseite mit Kontaktlappen der Leiterbahnen verschweißt, was später noch erläutert wird. Die Relais 7 bzw. 8 sitzen auf Abstandsnasen 12 bzw. Rippen 13. In Figur 1 ist eine Baugruppe mit nur einem Relais 7 und einem kleinen Relais 8 gezeigt, während rechts von dem Relais 8 ein Platz für ein weiteres Relais dieser Größe freibleibt. Dort sind die Stecköffnungen 11 für dieses zweite Relais zu sehen. Die Kontaktierung kann außer über die Flachstecker 10 auch beispielsweise über eine Litze 14 erfolgen, wie dies in den Figuren 1 und 2 ebenfalls zu sehen ist.

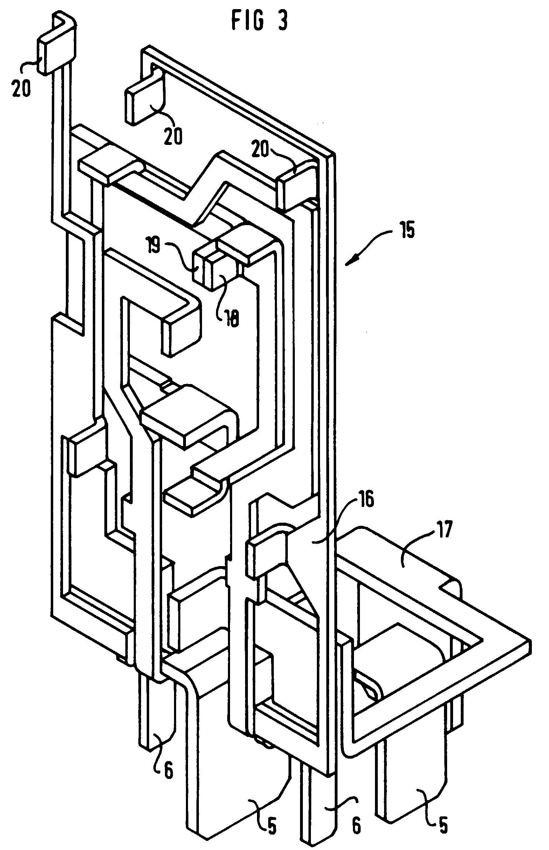

Die elektrischen Verbindungen zwischen den Anschlußstiften der Relais 7 und 8 sowie der übrigen Bauteile 9 untereinander und zu den Flachsteckern 5 und 6 erfolgt über Leiterbahnen 15, welche in der Leiterplatte 1 bei dem vorliegenden Beispiel im wesentlichen in zwei parallelen Ebenen eingebettet sind. Der Aufbau dieser Leiterplatte 1 mit den Leiterbahnen 15 ist anhand der Figuren 3 und 4 verdeutlicht. Die Figur 3 zeigt die Struktur der Leiterbahnen; diese besteht im vorliegenden Fall aus zwei Stanzgittern 16 und 17, diese erstrecken sich im wesentlichen in zwei zueinander parallelen Ebenen, welche hier senkrecht zur Einbauebene stehen. Im unteren Bereich sind diese Stanzgitter durch Abwinkelungen und Abkröpfungen in den Bereich des Sockels 3 erstreckt, von wo aus sie die nach unten abgebogenen Flachstecker 5 und 6 bilden.

Wie deutlich erkennbar ist, hat das Stanzgitter 16 eine geringere Dicke als das Stanzgitter 17, wobei das erstere im wesentlichen die Leiterbahnen und die Stecker 6 für die geringeren Steuerströme und letzteres die Leiterbahnen und die Stecker 5 für die stärkeren Lastströme bildet. An den Stellen, wo direkte elektrische Verbindungen zwischen den beiden Leiterbahngruppen erforderlich sind, werden diese über Verbindungslappen 18 und 19 vorgenommen, die aus der jeweiligen Leiterbahnebene herausgebogen sind und parallel aneinander anliegen, so daß sie leicht verschweißt werden können. Zur Kontaktierung von Bauelementen, insbesondere der eingesteckten Relais, dienen ferner abgebogene Kontaktlappen 20, welche im vorliegenden Beispiel alle zur Rückseite der Leiterplatte, von den eingesetzten Bauelementen aus gesehen, abgebogen sind.

Die beiden in ihren parallelen Ebenen zueinander ausgerichteten Stanzgitter 16 und 17 werden gemäß Figur 4 in Kunststoff eingebettet, wodurch die Leiterplatte 1 entsteht. Für die steckbaren Bauelemente, wie Relais, werden dabei durchgehende Stecköffnungen 11 ausgespart, die zumindest teilweise im Anschluß an einen Kontaktlappen 20 liegen. Beim Einstecken eines Relais oder eines anderen Bauteiles gemäß Figur 1 oder 2 liegen also die zu kontaktierenden Flachstecker 10 in ihrer Stecköffnung 11 an der Rückseite der Leiterplatte 1 bzw. 2 bereits an dem zugehörigen Kontaktlappen 20 elektrisch leitend an. Zur Sicherheit werden jedoch die Kontaktlappen 20 mit den entsprechenden Flachsteckern 10 der Relais bzw. anderer Bauelemente verschweißt. Dies kann auf der Rückseite der Leiterplatte 1 auf einfache Weise geschehen. Ein Teil der Stecköffnungen 11 kann aber auch zur rein mechanischen Halterung eines Bauteiles dienen, ohne daß dort eine Kontaktierung stattfinden müßte.

Für weitere Bauelemente 9 können, wie in Figur 4 gezeigt ist, größere Aussparungen 22 in der Leiterplatte 1 vorgesehen werden. In diesen Aussparungen 22 werden beispielsweise Dioden oder Widerstände 9 mit ihren Anschlußdrähten 23 an freigesparte Abschnitte der Leiterbahnen geschweißt; wahlweise wäre aber auch eine andere Kontaktierung, z. B. durch Löten oder Crimpen, möglich.

Es wären natürlich auch andere Konfigurationen der Leiterplatte denkbar, wobei auch mehr als zwei Leiterbahnebenen vorgesehen werden könnten oder auch Bauelemente von beiden Seiten in der Leiterplatte verankert werden könnten. Dabei ist zu erwähnen, daß die Stanzgitter, welche die verschiedenen Leiterbahnebenen bilden, nicht nur unterschiedliche Dicke haben können, sondern auch aus unterschiedlichen Materialien gefertigt sein können.

## Patentansprüche

1. Steckbare Baugruppe mit einer als Formteil aus Kunststoff gebildeten Leiterplatte (1), in welcher aus mindestens einem Stanzgitter (16, 17) gebildete Leiterbahnen (15) eingebettet sind, wobei auf der Leiterplatte (1) über die Leiterbahnen (15) elektrisch verbundene Bauelemente (7, 8, 9) befestigt sind und wobei an dem Stanzgitter (16, 17) einstückig angeformte Flachstecker (5, 6) aus der Leiterplatte (1) austreten, **dadurch gekennzeichnet,** daß die Leiterplatte (1) einstückig mindestens zwei zueinander senkrechte Leiterplattenebenen (2, 3) bildet, in denen sich das Stanzgitter (16, 17) innerhalb der Einbettung ebenfalls über mindestens zwei zueinander senkrechte Ebenen erstreckt, und daß eine waagerechte Leiterplattenebene einen Sockel (3) für mindestens eine senkrechte Leiterplattenebene (2) bildet, aus dessen Unterseite die Flachstecker (5, 6) austreten.

2. Baugruppe nach Anspruch 1, **dadurch gekennzeichnet,** daß zwei oder mehr als Stanzgitter (16, 17) ausgebildete Leiterbahngruppen in parallelen Ebenen angeordnet und von einem gemeinsamen Leiterplattenkörper (1) umhüllt sind.

3. Baugruppe nach Anspruch 2, **dadurch gekennzeichnet,** daß die Stanzgitter (16, 17) unterschiedliche Materialstärken besitzen.

4. Baugruppe nach Anspruch 2 oder 3, **dadurch gekennzeichnet,** daß die Stanzgitter (16, 17) aus unterschiedlichen Materialien gebildet sind.

5. Baugruppe nach einem der Ansprüche 1 bis 4, **dadurch gekennzeichnet,** daß die die Leiterbahnen (15) bildenden Stanzgitter (16, 17) allseitig von dem Kunststoff der Leiterplatte (1) umhüllt sind, wobei die Befestigungsstellen für die Bauelemente (7, 8, 9) freigespart sind.

6. Baugruppe nach einem der Ansprüche 1 bis 5, **dadurch gekennzeichnet,** daß in dem Leiterplattenkörper Aussparungen (22) zur versenkten Aufnahme kleinerer Bauelemente (9) vorgesehen sind.

7. Baugruppe nach einem der Ansprüche 1 bis 6, **dadurch gekennzeichnet,** daß die Leiterplatte (1) zur Steckbefestigung von größeren Bauteilen, wie Relais (7, 8), Durchbrüche (11) aufweist, und daß im Bereich der Durchbrüche Kontaktlappen (20) des Stanzgitters aus der Stanzgitterebene herausgebogen sind.

8. Baugruppe nach einem der Ansprüche 1 bis 7, **dadurch gekennzeichnet,** daß die Anschlüsse der Bauelemente (10; 23) mit den Leiterbahnen (15), insbesondere mit den Kontaktlappen (20) gemäß Anspruch 7, verschweißt sind.

9. Baugruppe nach einem der Ansprüche 1 bis 8, **dadurch gekennzeichnet,** daß eine über die Leiterplatte gestülpte Kappe (4) zusammen mit dem Sockel (3) ein geschlossenes Gehäuse bildet.

## Claims

1. Plug-in assembly having a printed circuit board (1) which is formed as a plastic moulding and in which conductor tracks (15) formed from at least one lead frame (16, 17) are embedded, components (7, 8, 9) which are electrically connected by means of the conductor tracks (15) being fastened on the printed circuit board (1) and blade terminals (5, 6) which are integrally formed on the lead frame (16, 17) emerging from the printed circuit board (1), characterized in that the printed circuit board (1) in one piece forms at least two mutually perpendicular printed circuit board planes (2, 3), in which the lead frame (16, 17) extends, within the embedding, likewise over at least two mutually perpendicular planes, and in that a horizontal printed circuit board plane forms a base (3) for at least one vertical printed circuit board plane (2), from the underside of which base the blade terminals (5, 6) emerge.

2. Assembly according to Claim 1, characterized in that two or more conductor track groups, formed as lead frames (16, 17), are arranged in parallel planes and are encapsulated by a common printed circuit board body (1).

3. Assembly according to Claim 2, characterized in that the lead frames (16, 17) have different material thicknesses.

4. Assembly according to Claim 2 or 3, characterized in that the lead frames (16, 17) are formed from different materials.

5. Assembly according to one of Claims 1 to 4, characterized in that the lead frames (16, 17) forming the conductor tracks (15) are encapsulated on all sides by the plastic of the printed circuit board (1), the fastening points for the components (7, 8, 9) being cut out.

6. Assembly according to one of Claims 1 to 5, characterized in that recesses (22) for the recessed accommodation of relatively small components (9) are provided in the printed circuit board body.

7. Assembly according to one of Claims 1 to 6, characterized in that the printed circuit board (1) has perforations (11) for the plug fastening of relatively large components, such as relays (7, 8), and in that contact tabs (20) of the lead frame are bent out of the lead frame plane in the region of the perforations.

8. Assembly according to one of Claims 1 to 7, characterized in that the terminals of the components (10; 23) are welded to the conductor tracks (15), in particular to the contact tabs (20) according to Claim 7.

9. Assembly according to one of Claims 1 to 8, characterized in that a cap (4) slipped over the printed circuit board forms a closed housing together with the base (3).

## Revendications

1. Unité enfichable comprenant une plaquette à circuit imprimé (1) formée en tant que préformé dans une matière plastique, dans laquelle des pistes conductives (15) formées par au moins une grille estampée (16, 17) sont enrobées, des composants (7, 8, 9) reliés électriquement par l'intermédiaire des pistes conductives (15) étant fixés sur la plaquette à circuit imprimé (1) et des fiches plates (5, 6) solidaires avec la grille estampée (16, 17) sortant de la plaquette à circuit imprimé (1), caractérisée en ce que la plaquette à circuit imprimé (1) forme au moins deux plans de plaquette à circuit imprimé (2, 3) perpendiculaires l'un par rapport à l'autre et solidaires, dans lesquels la grille estampée (16, 17), à l'intérieur de l'enrobage, s'étend également sur au moins deux plans perpendiculaires l'un par rapport à l'autre, et en ce qu'un plan de plaquette à circuit imprimé horizontal forme un socle (3) pour au moins un plan de plaquette à circuit imprimé vertical (2), socle de la face inférieure duquel sortent les fiches plates (5, 6).

2. Unité selon la revendication 1, caractérisée en ce que deux groupes ou plus de pistes conductives exécutées en tant que grilles estampées (16, 17) sont situés dans des plans parallèles et sont enveloppés par un corps de plaquette à circuit imprimé (1) commun.

3. Unité selon la revendication 2, caractérisée en ce que les grilles estampées (16, 17) ont des épaisseurs de matériau différentes.

4. Unité selon la revendication 2 ou 3, caractérisée en ce que les grilles estampées (16, 17) sont formées dans des matériaux différents.

5. Unité selon l'une des revendications 1 à 4, caractérisée en ce que les grilles estampées (16, 17) formant les pistes conductives (15) sont enveloppées sur tous les côtés par la matière plastique de la plaquette à circuit imprimé (1), les points de fixation pour les composants (7, 8, 9) étant ménagés.

6. Unité selon l'une des revendications 1 à 5, caractérisée en ce que l'on prévoit dans le corps de plaquette à circuit imprimé des évidements (22) destinés à recevoir de manière noyée des petits composants (9).

7. Unité selon l'une des revendications 1 à 6, caractérisée en ce que la plaquette à circuit imprimé (1) est pourvue de découpures (11) pour l'enfichage d'éléments assez gros, tels que des relais (7, 8), et en ce que, dans la zone des découpures, des languettes de contact (20) de la grille estampée sont pliées en dehors du plan de la grille estampée.

8. Unité selon l'une des revendications 1 à 7, caractérisée en ce que les connexions des composants (10; 23) sont soudées avec les pistes conductives (15), notamment avec les languettes de contact (20) selon la revendication 7.

9. Unité selon l'une des revendications 1 à 8, caractérisée en ce qu'un couvercle (4) posé par-dessus la plaquette à circuit imprimé forme, avec le socle (3), un boîtier fermé.
